# EUROPÄISCHE PATENTSCHRIFT

(11) **EP 3 876 358 B1**
(45) Veröffentlichungstag und Bekanntmachung des Hinweises auf die Patenterteilung: **01.11.2023**
(21) Anmeldenummer: 20160650.6
(22) Anmeldetag: 03.03.2020
(51) Int. Cl.: H01R 13/447, H01R 25/14, H02G 5/08, H01R 24/78

(54) **INDISKRETE KONTAKTIERUNGSANORDNUNG ZWISCHEN EINER STROMSCHIENENANORDNUNG EINER STROMEINSPEISUNG UND EINEM ABGRIFF EINES VERBRAUCHERS**
INDISCRETE CONTACT ARRANGEMENT BETWEEN A POWER RAIL ARRANGEMENT OF A POWER SUPPLY AND A SOCKET OF A CONSUMER
AGENCEMENT DE CONTACT INDISCRET ENTRE UN AGENCEMENT DE RAIL D'ALIMENTATION D'UNE ALIMENTATION ÉLECTRIQUE ET UNE PRISE D'UN CONSOMMATEUR

(43) Veröffentlichungstag der Anmeldung: 08.09.2021
(73) Patentinhaber: Siemens Aktiengesellschaft, 80333 München (DE)
(72) Erfinder: Althoff, Sebastian, 40789 Monheim am Rhein (DE); Bertels, Frank, 50765 Köln (DE); Rottländer, Dirk, 50859 Köln (DE); Haar, Rainer, 53121 Bonn (DE)
(74) Vertreter: Siemens Patent Attorneys

(56) Entgegenhaltungen:
- EP-A1- 0 396 437
- EP-A1- 2 930 803
- WO-A1-2012/038177
- DE-A1- 19 859 717
- US-A- 3 018 320
- US-A- 5 525 068

## Beschreibung

Die Erfindung betrifft eine indiskrete Kontaktierungsanordnung zwischen einer Stromschienenanordnung einer Stromeinspeisung und einem Abgriff eines Verbrauchers mit einer Stromschienenanordnung einer Stromeinspeisung, einem Gehäuse für die Stromschienenanordnung und Kontaktabgriffen eines Verbrauchers, sowie Anwendungsbeispiele für die indiskrete Kontaktierungsanordnung. Stromschienenanordnungen gemäß dem Stand der Technik sind in den Patentdokumenten EP 2 930 803 A1, DE 198 59 717 A1, US 5 525 068 A, US 3 018 320 A, EP 0 396 437 A1 und WO 2012/038177 A1 offenbart.

Stromschienensysteme sind üblicherweise mit diskreten Möglichkeiten zur Energieentnahme ausgestattet, sogenannten Abgangsstellen. Diese Abgangsstellen werden bei den marktüblichen Schienensystemen in luftisolierter oder gestapelter Bauweise mittels spezieller Isolierstoffteile und auf die Leiterschienen aufgebrachte Abgriffe realisiert. Auf diese Abgangsstellen wird ein Abgangskasten mittels eines Steckkontakts aufgesteckt, welcher den Stromabgriff an dieser dafür definierten Stelle ermöglicht. Insgesamt sind Position und Anzahl der möglichen Abgriffe also begrenzt auf die vorhandenen Abgangsstellen. Je nach System können entweder standardisierte Positionen in einer Rasterung oder in der Planungsphase einer Installation individuell vordefinierte Positionen verwendet werden.

In spezifischen Anwendungen ist es möglich, dass die konstruktiv vorgegebene Rasterung der Schienensysteme nicht zum notwendigen Raster der Verbraucher passt. Ein Beispiel hierfür sind Rechenzentren, in denen die Versorgung der einzelnen Serverracks über ein Stromschienensystem erfolgt. Die Stromschienensysteme sind hier üblicherweise in ca. 25m langen Linien von Serverschränken ("Racks") eingebaut, wobei ein einzelnes zu versorgendes Standardrack etwa 600mm breit ist.

Die Abgangsstellen des hier üblicherweise zur Versorgung verwendeten Systems liegen regulär 500mm auseinander. Damit ergibt sich im Verlauf des Schienenstrangs ein Versatz zwischen Abgangskasten und Verbraucher, der jeweils individuell kompensiert werden muss und die Erstellung von standardisierten Massenprodukten erschwert bzw. kostenintensiv gestaltet.

Die bekannten Lösungen sehen Stromschienenanordnungen mit jeweils einzelnen bzw. separat in geeigneten Gehäuseprofilen eingelegten Stromschienen vor, die auf eine dezidierte Abgangsstelle verzichten bzw. einen durchgehenden Zugriff auf die Stromschienen gewährleisten. Durch zusätzliche Maßnahmen wie Dichtungen oder eine konstruktive Verschachtelung werden die Leiterschienen gegen eine zufällige Berührung durch Personen von außen isoliert. Die Abgangskästen sind so konzipiert, dass die Kontakte durch einen speziellen Mechanismus eine Kontaktkraft auf der Stromschiene erzeugen. Dies kann beispielsweise ein Eindrehen des gesamten Kastens oder auch ein Hebel- oder Drehmechanismus sein. Alle bekannten Lösungen weisen ein geschlossenes Gehäuse für jede einzelne Stromschiene auf und greifen daher auf Kupfer als Leitermaterial, also auf reine Kupferschienen zurück, um einen Stromfluss mit teilweise bis zu 800 A auf dem relativ kleinen, zur Verfügung stehenden Bauraum zu ermöglichen.

Ein weiterer Nachteil dieses Konzepts besteht in der limitierten Ausbaufähigkeit des Systems, da eine weitere Optimierung des Strombereichs kaum noch zu erreichen ist. Da die Leistung von Rechenzentren auf absehbare Zeit noch weiterwachsen wird, ist zu erwarten, dass die benötigten Stromflüsse den Leistungsbereich der auf dem Markt befindlichen Systeme in absehbarer Zeit überschreiten werden.

Demgemäß besteht die Aufgabe der vorliegenden Erfindung darin, eine einfach ausgeführte und hinsichtlich der übertragenen Stromleistung erweiterbare Kontaktierungsanordnung zwischen einer Stromschienenanordnung einer Stromeinspeisung und einem Abgriff eines Verbrauchers zu schaffen sowie Anwendungsbeispiele anzugeben.

Diese Aufgabe wird erfindungsgemäß durch eine indiskrete Kontaktierungsanordnung nach Anspruch 1 gelöst und findet in Anwendungsbeispielen gemäß der Ansprüche 11 und 12 eine Anwendung. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe gelöst durch eine indiskrete Kontaktierungsanordnung zwischen einer Stromschienenanordnung einer Stromeinspeisung und einem Abgriff eines Verbrauchers mit:
- einer Stromschienenanordnung einer Stromeinspeisung, welche eine Mehrzahl an Stromschienen aus einem elektrisch leitenden Material aufweist, wobei elektrische Kontaktierungen über Längsseitenkanten der Stromschienen ausgebildet sind;
- einem Gehäuse für die Stromschienenanordnung, wobei mindestens ein Seitenteil des Gehäuses eine Rasterung mit Durchgriffsöffnungen aufweist für elektrische Kontaktierungen; und
- Kontaktabgriffen derart ausgebildet, dass die Kontaktabgriffe durch die Durchgriffsöffnungen des Seitenteils des Gehäuses mit Rasterung auf die Stromschienen kontaktieren.

Erfindungsgemäß sind an den Kontaktabgriffen Gleitelemente angeordnet, welche in Führungsschienen eines Abgangskastens zu positionieren sind.

Eine indiskrete Kontaktierungsanordnung ist als völlig frei wählbare Kontaktierung auf einer Stromschiene ausgebildet, d.h. jede Position auf der Stromschiene ist elektrisch zu kontaktieren, es gibt keine definierten Abgangsstellen. Die Position des Abgriffs ist abgangsstellenfrei, d.h. nicht vordefiniert. Die Position und Anzahl der möglichen Abgriffe sind begrenzungsfrei.

Der Ausgangspunkt für die vorliegende Erfindung ist ein luftisoliertes Schienensystem. Der Grundaufbau dieses Systems bildet die Grundlage für die erfindungsgemäß verwendete Stromschienenanordnung, welche ein Schienenpaket, vorzugsweise aus Aluminiumschienen, aufweist, welche parallel nebeneinander angeordnet und durch Isolierstoffteile voneinander getrennt sind. Das Schienenpaket wird durch gleitend gelagerte Fixierungselemente im Gehäusekanal positioniert, um die thermisch bedingte Relativbewegung zwischen Gehäuse und Aluminiumschiene zu kompensieren. Der konstruktive Aufbau der Stromschienenanordnung ist durch mittig, also nicht sandwichartig übereinander, sondern parallel nebeneinander angeordnete Stromschienen gekennzeichnet, so dass die Leiterlängskanten der Stromschienen als Kontaktierungsfläche genutzt werden können. Ferner wird der Abstand zwischen den Leiterschienen erhöht und so Raum für einen elektrischen Kontakt geschaffen.

Eine vorteilhafte Kontaktierungsanordnung kann darin bestehen, die Abgangskästen von unten an die Stromschiene zu führen, da beispielsweise die Versorgung von Serverracks in Rechenzentren in der überwiegenden Zahl von oben erfolgt.

Die Leiterschienen können mit einer Isolierstoffbeschichtung versehen sein, die jedoch primär der Wärmeabfuhr und somit der höheren Strombelastbarkeit dient. Um die Kontaktierung auf der Schienenunterseite zu ermöglichen, wird hier auf der Unterseite längs der Leiterprofile keine Beschichtung aufgebracht. Sofern es die thermischen Verhältnisse zulassen, kann bei einzelnen Systemvarianten gänzlich auf eine Pulverbeschichtung verzichtet werden.

Das erfindungsgemäße Gehäuse für die Stromschienenanordnung weist zumindest an einer Seitenwand eine Rasterung mit regelmäßig oder unregelmäßig angeordneten Durchgriffsöffnungen auf. Die Kontakte des Abgangskastens werden so ausbildet, dass sie durch diese Rasterung greifen und so die Kontaktierung zwischen den Stromschienen und dem Abgangskasten ermöglichen. Die Durchgriffsöffnungen der Rasterung dienen der Positionierung des Abgangskastens am Gehäuse für die Stromschienen, so dass eine korrekte Einführung der Durchgriffskontakte gewährleistet ist. Die Seitenwand mit der Rasterung wird vorzugsweise aus Kunststoff ausgeführt, um das Risiko eines Kurzschlusses während des Aufsteckvorgangs auszuschließen.

Die erfindungsgemäßen Abgangskästen erhalten eine Kontaktierungsanordnung, welche auf die oben definierten Stromschienen abgestimmt ist. Die Kontaktabgriffe folgen vorzugsweise dem Lyra-Prinzip und umschließen das Schienenprofil vorzugsweise im Bereich einer Verjüngung, wodurch die erreichbare Kontaktkraft und die zum Aufstecken benötigte Kraft durch das Zusammenspiel zwischen der Federkraft des Lyra-Kontakts und der Dicke der Verjüngung gesteuert werden.

Der Kern der Erfindung besteht in der Kombination eines luftisolierten Aufbaus für die Stromschienenanordnung in einem speziell konzipierten Gehäuse mit mindestens einem Seitenteil mit einer Rasterung mit Durchgriffsöffnungen vorzugsweise aus Kunststoff gefertigt und elektrisch leitenden, gleitend gelagerten Durchgriffskontakten für den Stromabgriff zum Abgangskasten bzw. Verbraucher.

Luftisolierte Schienensysteme können teilweise sehr hohe Leitertemperaturen, in der hier vorliegenden Ausführungsvariante bis zu 140°C, erreichen. Daher bestehen hinsichtlich der thermisch bedingten Ausdehnungstoleranz besondere Anforderungen an das Leitermaterial.

Während üblicherweise eine diskrete Abgangsstelle einen konstruktiven Fix- bzw. Nullpunkt der thermischen Ausdehnung darstellt, d.h. nur geringe Relativbewegungen zwischen Leiterschienen des Stromschienensystems und Kontakten des Abgangskastens vollzogen werden, kann das in einer Anordnung ohne diskrete Abgangsstellen nicht in gleicher Weise gewährleistet werden. Da eine Relativbewegung aufgrund eines vorhandenen Kontaktverschleißes aber vermieden werden muss, wird der Kontakt so ausgeführt, dass er von der zu erwartenden thermisch bedingten Längenänderung der Leiterschiene mitgeführt wird. Dies erfolgt durch eine geeignete Lagerung innerhalb der Trägerbaugruppe im Abgangskasten sowie durch die geeignete Ausgestaltung der Rasterung im Seitenteil des Gehäuses für die Schienenanordnung. Indem eine der Längenausdehnung der Leiterschienen angemessene Längsausdehnung der Durchgriffsöffnungen im Seitenteil mit Rasterung im vorgegebenen Temperaturbereich gewählt wird bzw. eine geeignete longitudinale Bewegungsfreiheit des Kontakts ermöglicht wird, kann die Kontaktierung auch bei ständig wechselnden Betriebsbedingungen verschleißfrei arbeiten.

Die Kontaktierung des beweglich gelagerten Kontakts innerhalb des Abgangskastens zu anderen, fixierten Bauelementen, wie z.B. einem Leistungsschalter, ist dann über flexible Verbindungen z.B. Kabel ausgebildet, die so gewählt und angeordnet werden, dass sie die Relativbewegung des Kontakts kompensieren können.

Eine Fortführung des erfindungsgemäßen Konzepts für die indiskrete Kontaktierungsanordnung kann vorsehen, dass das elektrisch leitende Material reinkupferfrei ist. Stromschienen aus einem reinkupferfreien, elektrisch leitenden Material schließt reine Kupferschienen aus, umfasst jedoch Stromschienen mit bewusst gewählten Kupferbeimengungen oder Kupferverunreinigungen, kupferhaltigen Legierungen, reinkupferhaltigen oder kupferhaltigen Implantaten oder reinkupferhaltigen oder kupferhaltigen vollflächigen oder teilweise ausgebildeten Beschichtungen bzw. alle weiteren kupferhaltigen, elektrisch leitenden Materialien.

Eine vorteilhafte Ausführungsform der erfindungsgemäßen indiskreten Kontaktierungsanordnung kann darin bestehen, dass die Stromschienen Aluminium aufweisen.

Es entspricht einer speziellen Ausführungsform der erfindungsgemäßen indiskreten Kontaktierungsanordnung, dass die Stromschienen Legierungen und/oder leitfähige Komposite und/oder Verbindungen und/oder weitere Metalle aufweisen. Leitfähige Komposite können beispielsweise geschmolzene Einzelbestandteile sein, welche zusammengeführt wurden. Verbindungen können beispielsweise reine CNT- oder CNThaltige Verbindungen sein oder andere organische oder anorganische Verbindungen oder Kombinationen daraus.

Eine Fortführung des Konzepts für die erfindungsgemäße indiskrete Kontaktierungsanordnung kann darin bestehen, dass die einzelne Stromschiene einer Mehrzahl an Stromschienen gehäusefrei und die Mehrzahl an Stromschienen als Schienenpaket in einem Gehäuse angeordnet sind.

Eine Erweiterung einer speziellen Ausgestaltung des erfindungsgemäßen Konzepts für die indiskrete Kontaktierungsanordnung kann vorsehen, dass die Stromschienen im Gehäuse durch Fixierungselemente, vorzugsweise gleitend gelagert sind. Die Halterung für das Stromschienenpaket weist zwei Endbereiche auf, welche derart ausgebildet sind, dass zwei Fixierungselemente angeschlossen werden können. Vorzugsweise werden die Fixierungselemente in erweiterten Gehäusebereichen bzw. Gehäuseausbuchtungen gelagert. Die Fixierungselemente umfassen zwei U-förmige Bereiche, welche an den Gehäusewänden der Gehäuseausbuchtungen anliegen und welche über einen Mittelbereich, an welchem jeweils die Halterung eingreift, miteinander verbunden sind.

Eine vorteilhafte Ausführungsform der erfindungsgemäßen indiskreten Kontaktierungsanordnung kann darin bestehen, dass die elektrische Isolierung der Stromschienen durch eine teilweise oder komplett ausgeführte Isolierstoffbeschichtung ausgebildet ist.

Eine Fortführung des erfindungsgemäßen Konzepts für die indiskrete Kontaktierungsanordnung kann vorsehen, dass die elektrische Isolierung der Stromschienen dichtungsfrei ausgebildet ist und/oder frei ist von konstruktiven Maßnahmen für die elektrische Isolierung. Unter den Begriff konstruktive Maßnahmen fallen alle baulichen Ausgestaltungen, die den Zweck verfolgen, eine elektrische Isolierung auszubilden, um Personenschäden auszuschließen.

Es entspricht einer speziellen Ausführungsform der erfindungsgemäßen indiskreten Kontaktierungsanordnung, dass das mindestens eine Seitenteil des Gehäuses mit Rasterung für eine elektrische Kontaktierung aus einem elektrisch nicht-leitenden Material, vorzugsweise Kunststoff gefertigt ist.

Eine spezielle Ausgestaltung der erfindungsgemäßen indiskreten Kontaktierungsanordnung kann darin bestehen, dass die Kontaktabgriffe derart ausgebildet sind, dass die Kontaktabgriffe die Stromschienen mit einer Federkraft kontaktieren.

Ein erstes Anwendungsbeispiel der erfindungsgemäßen indiskreten Kontaktierungsanordnung ist eine Verwendung in einem Rechenzentrum.

Ein zweites Anwendungsbeispiel der erfindungsgemäßen indiskreten Kontaktierungsanordnung ist eine Verwendung beim Bühnenbau beispielsweise beim Fernsehen, im Theater oder beim Messebau.

Weitere Ausführungen und Vorteile der Erfindung werden nachfolgend anhand von Ausführungsbeispielen sowie anhand der Zeichnung erläutert.

Dabei zeigt:
Fig. 1 in einer schematischen Darstellung eine Ausführungsform einer erfindungsgemäßen Stromschienenanordnung;
Fig. 2 in einer Seitenansicht eine Stromschiene mit einer teilweise aufgetragenen Isolierstoffbeschichtung sowie einem unbeschichteten Bereich;
Fig. 3 in einer perspektivischen Darstellung ein erfindungsgemäßes Gehäuse für die Stromschienenanordnung;
Fig. 4 in einer perspektivischen Darstellung eine erfindungsgemäße indiskrete Kontaktierungsanordnung mit einer Stromschienenanordnung in einem Gehäuse für eine Stromeinspeisung und einen Kontaktabgriff eines Verbrauchers in Form eines Abgangskastens;
Fig. 5 in einer perspektivischen Darstellung die Kontaktierungsschnittstelle der erfindungsgemäßen indiskreten Kontaktierungsanordnung;
Fig. 6 in einer perspektivischen Darstellung der erfindungsgemäße Kontaktabgriff;
Fig. 7 in einer perspektivischen Darstellung der erfindungsgemäße Kontaktabgriff nach Fig. 6 in Führungsschienen des Abgangskastens positioniert.

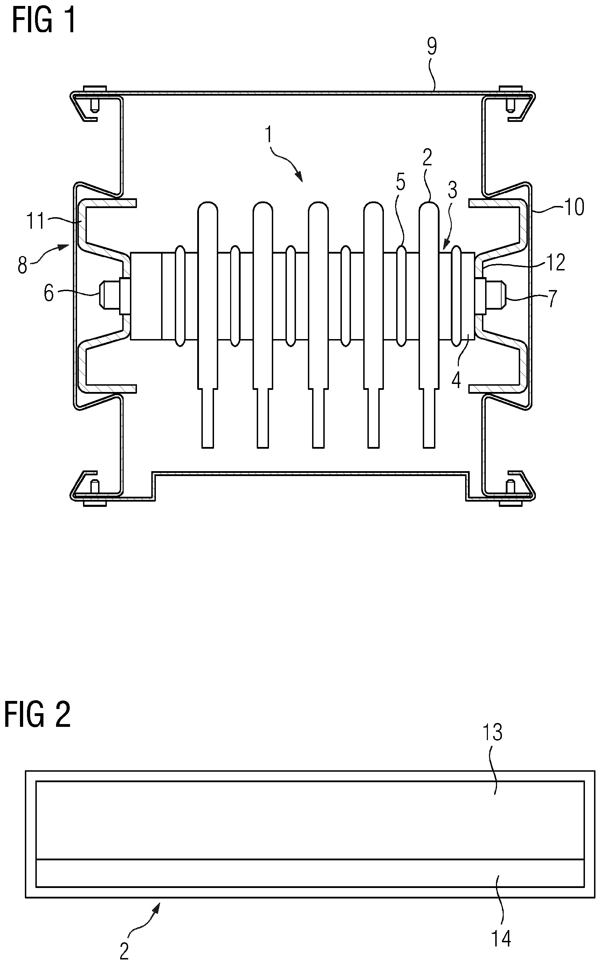

Fig. 1 zeigt eine Ausführungsform einer erfindungsgemäßen Stromschienenanordnung. Die Stromschienenanordnung umfasst ein Schienenpaket 1, vorzugsweise aus einer Mehrzahl an Stromschienen 2, insbesondere Aluminiumschienen, welche positionsgleich hinsichtlich eines Endbereichs der Stromschienen 2 und parallel, vorzugsweise nebeneinander, angeordnet sind. Die Stromschienen 2 weisen eine Durchgriffsöffnung 3 auf, durch welche eine Halterung 4 geführt ist. Zwischen den einzelnen Stromschienen 2 des Schienenpakets 1 auf der Halterung 4 befinden sich stromisolierende Elemente 5. Die Halterung 4 weist zwei Endbereiche 6, 7 auf, welche mittels Fixierungselementen 8, vorzugsweise gleitend, in einem Gehäuse 9 positioniert sind. Vorzugsweise werden die Fixierungselemente 8 in erweiterten Gehäusebereichen 10 bzw. Gehäuseausbuchtungen gelagert. Die Fixierungselemente 8 umfassen zwei U-förmige Bereiche 11, welche an den Gehäusewänden der Gehäuseausbuchtungen anliegen und welche über einen Mittelbereich 12, an welchem jeweils die Halterung 4 eingreift, miteinander verbunden sind.

In Fig. 2 ist eine Stromschiene 2 mit einer teilweise aufgetragenen Isolierstoffbeschichtung 13 sowie einem unbeschichteten Bereich 14 dargestellt. Die Isolierstoffbeschichtung 13 dient primär der Wärmeabfuhr und somit der höheren Strombelastbarkeit. Um die Kontaktierung auf der Stromschienenunterseite, also der Längsseitenkante der Stromschiene 2, zu ermöglichen, wird hier auf der Unterseite längs des Leiterprofils keine Beschichtung aufgebracht. Sofern es die thermischen Verhältnisse zulassen, kann bei einzelnen Systemvarianten gänzlich auf eine Pulverbeschichtung verzichtet werden.

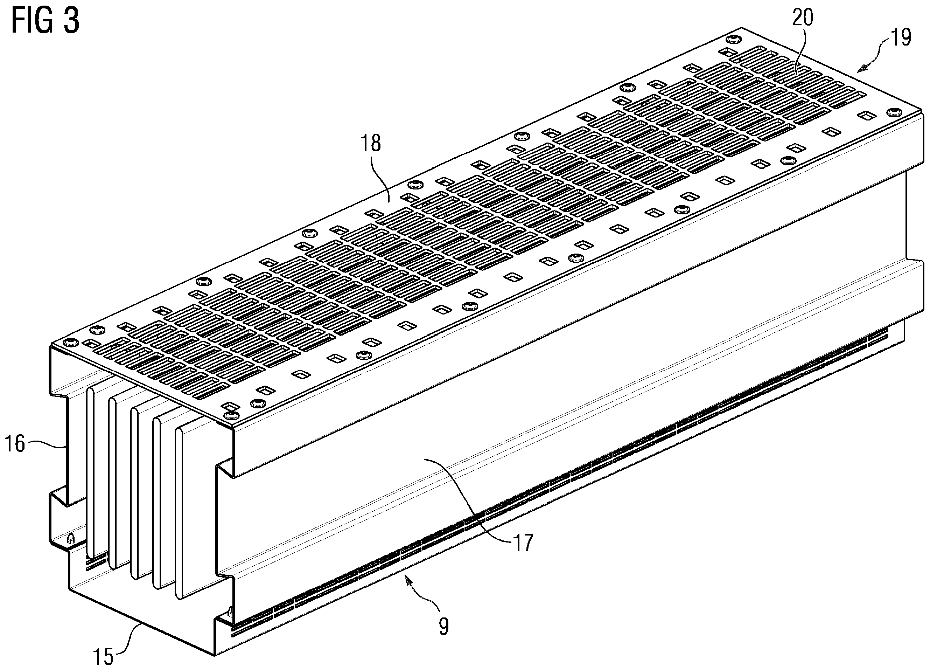

Fig. 3 zeigt das Gehäuse 9 für die erfindungsgemäße Stromschienenanordnung. Das Gehäuse 9 ist vorzugsweise quaderförmig mit vier Seitenteilen 15, 16, 17, 18 ausgebildet. Zumindest ein Seitenteil 18 weist eine Rasterung 19 in Form von gleichmäßig oder/und ungleichmäßig verteilten Durchgriffsöffnungen 20 auf. Die Durchgriffsöffnungen 20 ermöglichen es, einen Abgangskasten mit Durchgriffskontakten auf bzw. unter dem Gehäuse 9 zu positionieren. Das Seitenteil 18 mit der Rasterung 19 wird aus einem elektrisch nicht-leitenden Material, vorzugsweise aus Kunststoff ausgeführt, um das Risiko eines Kurzschlusses während des Aufsteckvorgangs auszuschließen. Die Seitenteile 15, 16, 17, 18 sind durch eine Verbindungstechnik wie beispielsweise klemmen, verrasten, verschrauben, vernieten oder Ähnliches ineinandergefügt.

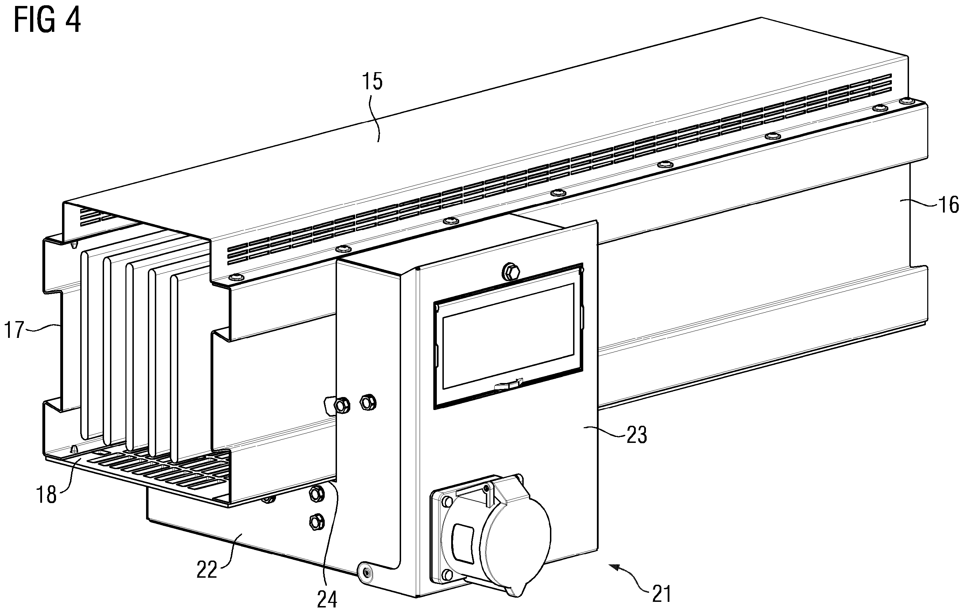

In Fig. 4 ist eine erfindungsgemäße indiskrete Kontaktierungsanordnung mit einer Stromschienenanordnung in einem Gehäuse 9 für eine Stromeinspeisung und einen Kontaktabgriff eines Verbrauchers in Form eines Abgangskastens 21 dargestellt. Der Abgangskasten 21 ist vorzugsweise in L-Form mit zwei Schenkeln 22, 23 ausgeführt, wobei das Gehäuse 9 inklusive der Stromschienenanordnung über das Seitenteil 18 mit der Rasterung 19 auf einer Oberseite 24 des Schenkels 22 des Abgangskastens 21 anliegt. Der Abgangskasten 21 stellt eine mögliche Ausprägungsvariante dar, alternativ kann er auch eine klassische quaderförmige Variante bzw. jede andere Bauform aufweisen. Vorzugsweise kann der Schenkel 23 des Abgangskastens 21 am Seitenteil 16 des Gehäuses 9 anliegen.

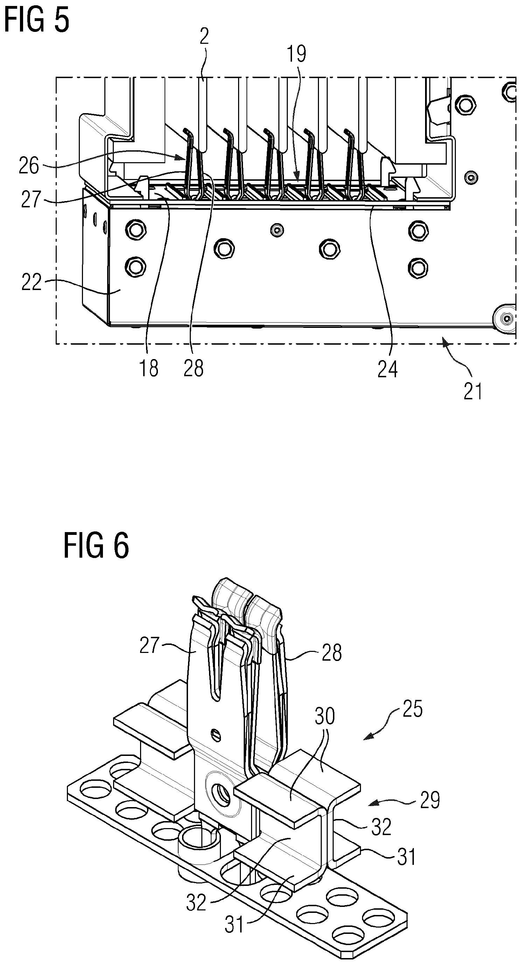

Fig. 5 zeigt die Kontaktierungsschnittstelle der erfindungsgemäßen indiskreten Kontaktierungsanordnung. Im Abgangskasten 21 sind Kontaktabgriffe 25 (nicht dargestellt), vorzugsweise Lyra-Kontakte angeordnet, welche durch die Oberseite 24 des Schenkels 22 des Angangskastens 21 sowie durch das Seitenteil 18 des Gehäuses 9 geführt sind. Im Gehäuse 9 kontaktieren die Kontaktabgriffe 25 (nicht dargestellt) die Stromschienen 2, vorzugsweise federnd. Eine federnde Kontaktierung wird durch eine U-förmige Ausbildung eines Zugriffskontakts 26 des Kontaktabgriffs 25 (nicht dargestellt) mit zwei Kontaktzungen 27, 28 umgesetzt. Die Stromschiene 2 ist bei dieser Ausführungsform zwischen den Kontaktzungen 27, 28 angeordnet.

In Fig. 6 ist der erfindungsgemäße Kontaktabgriff 25 dargestellt. Der Kontaktabgriff 25 ist in dieser Ausführungsform vorzugsweise U-förmig ausgebildet mit den zwei sich parallel gegenüberliegenden Kontaktzungen 27, 28, an welchen seitlich anliegend Gleitelemente 29, vorzugsweise in einer Sandwich-Anordnung, also die Kontaktzungen 27, 28 positioniert zwischen Gleitelementen 29, angeordnet sind. Die Gleitelemente 29 sind vorzugsweise U-förmig ausgebildet mit zwei sich parallel gegenüberliegenden Schenkeln 30, 31 und einem die beiden Schenkel 30, 31 verbindenden Mittelbereich 32. Jeweils zwei Gleitelemente 29 liegen sich spiegelsymmetrisch auf einer Seite der Kontaktzungen 27, 28 gegenüber, wobei sie vorzugsweise an ihren Mittelbereichen 32 aneinander liegen.

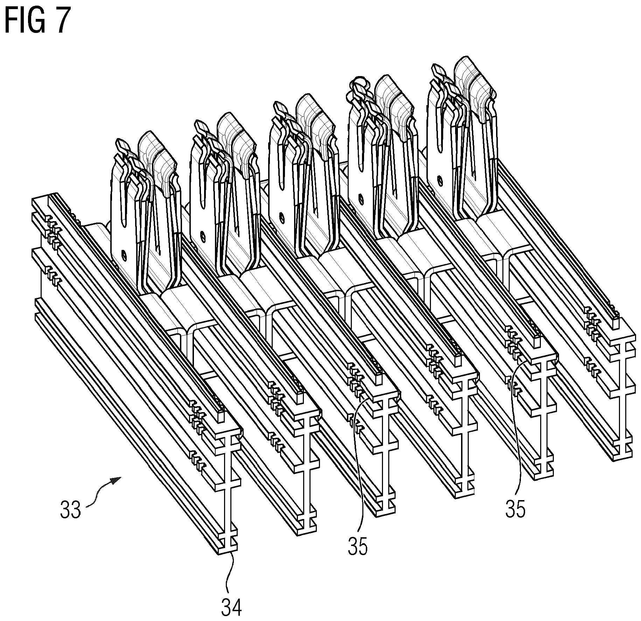

Fig. 7 zeigt den erfindungsgemäßen Kontaktabgriff 25 nach Fig. 6, positioniert in einer Führungsvorrichtung 33 des Abgangskastens 21. Die Führungsvorrichtung 33 ist aus einzelnen, separaten, vorzugsweise parallel zueinander ausgerichteten Gehäusewänden 34 ausgebildet. Die Gehäusewände 34 weisen Führungsschienen 35 auf, in welchen die Schenkel 30, 31 der Gleitelemente 29 gleitend lagern. Durch diese gleitende Lagerung der Durchgriffskontakte 25 können sich diese individuell mit der thermischen Ausdehnung der Stromschiene 2 bewegen, ohne dass es zu einem Verschleiß am Übergang zwischen Kontakt und Leiterschiene kommt. Da die parallel geführten Leiterschienen je nach Temperaturverteilung verschiedene Längenausdehnungen aufweisen, ist die Kontaktierungsanordnung so ausgelegt, dass eine individuelle Verschiebung jedes einzelnen Kontaktabgriffs 25 möglich ist. Die weitere elektrische Kontaktierung innerhalb des Abgangskastens 21 erfolgt dann über flexible Leitungen bis zu einem Schaltgerät.

Die hier vorgestellte Lösung stellt eine kostengünstige Alternative für die Umsetzung einer abgangsstellenfreien Kontaktierung auf einem Stromschienensystem dar. Sie ermöglicht durch die individuelle Ausgestaltung der Stromschienenanordnung, des Gehäuses für die Stromschienen und der gleitenden Kontaktabgriffe die Umsetzung wesentlich höherer Ströme, ohne dabei auf Kupfer als Hauptleitermaterial ausweichen zu müssen, da die Verlustwärme nicht durch enge Gehäusebauformen gestaut wird und so eine Ausnutzung des Leiterquerschnitts optimiert wird.

Die erfindungsgemäße Kontaktierungsanordnung erlaubt zudem eine Erweiterung durch eine Anpassung der Profilhöhe auf der nicht kontaktierenden Systemseite sowie durch den zahlenmäßigen Ausbau an parallelen Leiterprofilen pro Hauptleiter. Die hier vorgestellte Erfindung verbindet die Vorteile einer luftisolierten Aufbauweise eines Stromschienensystems unter Verzicht auf dezidierte Abgangsstellen. Die Ausgestaltung für die gleitend gelagerten Kontaktabgriffe der Stromabgriffe in den Abgangskasten erlaubt eine verschleißfreie Kontaktierung, welche sonst nur durch massive Konstruktionsteile bzw. durch den Einsatz aufwändiger verschleißarmer Kontakttechnologien beispielsweise einer Silberbeschichtung u.ä. umzusetzen ist.

### Bezugszeichenliste

- 1: Schienenpaket
- 2: Stromschienen
- 3: Durchgriffsöffnung
- 4: Halterung
- 5: stromisolierendes Element
- 6: Endbereich
- 7: Endbereich
- 8: Fixierungselement
- 9: Gehäuse
- 10: erweiterter Gehäusebereich
- 11: U-förmige Bereiche
- 12: Mittelbereich
- 13: Isolierstoffbeschichtung
- 14: Unbeschichteter Bereich
- 15: Seitenteil
- 16: Seitenteil
- 17: Seitenteil
- 18: Seitenteil
- 19: Rasterung
- 20: Durchgriffsöffnung
- 21: Abgangskasten
- 22: Schenkel
- 23: Schenkel
- 24: Oberseite
- 25: Kontaktabgriff
- 26: Zugriffskontakt
- 27: Kontaktzunge
- 28: Kontaktzunge
- 29: Gleitelement
- 30: Schenkel
- 31: Schenkel
- 32: Mittelbereich
- 33: Führungsvorrichtung
- 34: Gehäusewand
- 35: Führungsschiene

## Patentansprüche

1. Indiskrete Kontaktierungsanordnung zwischen einer Stromschienenanordnung einer Stromeinspeisung und einem Abgriff eines Verbrauchers mit:
- der Stromschienenanordnung der Stromeinspeisung, welche eine Mehrzahl an Stromschienen (2) aus einem elektrisch leitenden Material aufweist, wobei elektrische Kontaktierungen über Längsseitenkanten der Stromschienen (2) ausgebildet sind;
- einem Gehäuse (9) für die Stromschienenanordnung, wobei mindestens ein Seitenteil (18) des Gehäuses (9) eine Rasterung (19) mit Durchgriffsöffnungen (20) aufweist für elektrische Kontaktierungen; und
- Kontaktabgriffen (25) des Verbrauchers derart ausgebildet, dass die Kontaktabgriffe (25) durch die Durchgriffsöffnungen (20) des Seitenteils (18) des Gehäuses (9) mit Rasterung (19) auf die Stromschienen (2) kontaktieren, **dadurch gekennzeichnet, dass** an den Kontaktabgriffen (25) Gleitelemente (29) angeordnet sind, welche in Führungsschienen (35) eines Abgangskastens zu positionieren sind.

2. Indiskrete Kontaktierungsanordnung nach Anspruch 1, **dadurch gekennzeichnet, dass** das elektrisch leitende Material reinkupferfrei ist.

3. Indiskrete Kontaktierungsanordnung nach Anspruch 1 oder 2, **dadurch gekennzeichnet, dass** die Stromschienen (2) Aluminium aufweisen.

4. Indiskrete Kontaktierungsanordnung nach einem der Ansprüche 1 bis 3, **dadurch gekennzeichnet, dass** die Stromschienen (2) Legierungen und/oder leitfähige Komposite und/oder Verbindungen und/oder weitere Metalle aufweisen.

5. Indiskrete Kontaktierungsanordnung nach einem der Ansprüche 1 bis 4, **dadurch gekennzeichnet, dass** die einzelne Stromschiene (2) einer Mehrzahl an Stromschienen (2) gehäusefrei und die Mehrzahl an Stromschienen (2) als Schienenpaket (1) in einem Gehäuse (9) angeordnet sind.

6. Indiskrete Kontaktierungsanordnung nach einem der Ansprüche 1 bis 5, **dadurch gekennzeichnet, dass** die Stromschienen (2) im Gehäuse (9) durch Fixierungselemente (8) gelagert sind.

7. Indiskrete Kontaktierungsanordnung nach einem der Ansprüche 1 bis 6, **dadurch gekennzeichnet, dass** die elektrische Isolierung der Stromschienen (2) durch eine teilweise oder komplett ausgeführte Isolierstoffbeschichtung (13) ausgebildet ist.

8. Indiskrete Kontaktierungsanordnung nach einem der Ansprüche 1 bis 7, **dadurch gekennzeichnet, dass** die elektrische Isolierung der Stromschienen (2) dichtungsfrei ausgebildet ist und/oder frei ist von konstruktiven Maßnahmen für die elektrische Isolierung.

9. Indiskrete Kontaktierungsanordnung nach einem der Ansprüche 1 bis 8, **dadurch gekennzeichnet, dass** das mindestens eine Seitenteil (18) des Gehäuses (9) mit Rasterung (19) für eine elektrische Kontaktierung aus einem elektrisch nicht-leitenden Material gefertigt ist.

10. Indiskrete Kontaktierungsanordnung nach einem der Ansprüche 1 bis 9, **dadurch gekennzeichnet, dass** die Kontaktabgriffe (25) derart ausgebildet sind, dass die Kontaktabgriffe (25) die Stromschienen (2) mit einer Federkraft kontaktieren.

11. Verwendung einer indiskreten Kontaktierungsanordnung nach einem der Ansprüche 1 bis 10 in einem Rechenzentrum.

12. Verwendung einer indiskreten Kontaktierungsanordnung nach einem der Ansprüche 1 bis 10 beim Bühnenbau.

## Claims

1. Indiscrete contact arrangement between a power rail arrangement of a power supply and a socket of a consumer, comprising:
- the power rail arrangement of the power supply, which has a plurality of power rails (2) made of an electrically conductive material, electrical contacts being formed via longitudinal side edges of the power rails (2);
- a housing (9) for the power rail arrangement, at least one side part (18) of the housing (9) having a grid (19) with passage openings (20) for electrical contacts; and
- contact taps (25) of the consumer, formed in such a way that the contact taps (25) contact the power rails (2) through the passage openings (20) of the side part (18) of the housing (9) with the grid (19), **characterized in that** sliding elements (29), which are to be positioned in guide rails (35) of an outlet box, are arranged on the contact taps (25).

2. Indiscrete contact arrangement according to Claim 1, **characterized in that** the electrically conductive material is free of pure copper.

3. Indiscrete contact arrangement according to Claim 1 or 2, **characterized in that** the power rails (2) have aluminium.

4. Indiscrete contact arrangement according to one of Claims 1 to 3, **characterized in that** the power rails (2) have alloys and/or conductive composites and/or compounds and/or further metals.

5. Indiscrete contact arrangement according to one of Claims 1 to 4, **characterized in that** the individual power rail (2) of a plurality of power rails (2) has no housing, and the plurality of power rails (2) are arranged as a rail pack (1) in a housing (9).

6. Indiscrete contact arrangement according to one of Claims 1 to 5, **characterized in that** the power rails (2) are supported in the housing (9) by fastening elements (8).

7. Indiscrete contact arrangement according to one of Claims 1 to 6, **characterized in that** the electrical insulation of the power rails (2) is formed by a partly or completely implemented insulating material coating (13).

8. Indiscrete contact arrangement according to one of Claims 1 to 7, **characterized in that** the electrical insulation of the power rails (2) is formed without any seal and/or is free of constructive measures for the electrical insulation.

9. Indiscrete contact arrangement according to one of Claims 1 to 8, **characterized in that** the at least one side part (18) of the housing (9) with a grid (19) for electrical contact is produced from an electrically non-conductive material.

10. Indiscrete contact arrangement according to one of Claims 1 to 9, **characterized in that** the contact taps (25) are formed in such a way that the contact taps (25) contact the power rails (2) with a spring force.

11. Use of an indiscrete contact arrangement according to one of Claims 1 to 10 in a computing centre.

12. Use of an indiscrete contact arrangement according to one of Claims 1 to 10 in stage construction.

## Revendications

1. Agencement indiscret de mise en contact entre un agencement de rails d'alimentation d'une alimentation électrique et une prise d'un consommateur, comprenant :
- l'agencement d'alimentation en courant de l'alimentation électrique, qui a une pluralité de rails (2) d'alimentation en un matériau conducteur de l'électricité, dans lequel des mises en contact électriques sont constituées par des bords latéraux longitudinaux des rails (2) d'alimentation ;
- un enveloppe (9) pour l'agencement de rails d'alimentation, dans lequel au moins une partie (18) latérale de l'enveloppe (9) a un tramage (19) ayant des ouvertures (20) de pénétration pour des mises en contact électriques ; et
- des prises (25) de contact du consommateur constituées de manière à ce que les prises (25) de contact soient, en passant par les ouvertures (20) de pénétration de la partie (18) latérale de l'enveloppe (9), mises en contact avec le tramage (19) sur les rails (2) d'alimentation, **caractérisé en ce que**, sur les prises (25) de contact sont montés des éléments (29) de glissement, qui sont mis en position dans des rails (35) de guidage d'un caisson de sortie.

2. Agencement indiscret de mise en contact suivant la revendication 1, **caractérisé en ce que** le matériau conducteur de l'électricité est exempt de cuivre pur.

3. Agencement indiscret de mise en contact suivant la revendication 1 ou 2, **caractérisé en ce que** les rails (2) d'alimentation ont de l'aluminium.

4. Agencement indiscret de mise en contact suivant l'une des revendications 1 à 3, **caractérisé en ce que** les rails (2) d'alimentation ont des alliages et/ou des composites conducteurs et/ou des composés et/ou d'autres métaux.

5. Agencement indiscret de mise en contact suivant l'une des revendications 1 à 4, **caractérisé en ce que** les rails (2) d'alimentation individuels d'une pluralité de rails (2) d'alimentation sont disposés sans enveloppe et la pluralité de rails (2) d'alimentation est disposée sous la forme d'un paquet (1) de rails dans une enveloppe (9).

6. Agencement indiscret de mise en contact suivant l'une des revendications 1 à 5, **caractérisé en ce que** les rails (2) d'alimentation sont montés dans l'enveloppe (9) par des éléments (8) de fixation.

7. Agencement indiscret de mise en contact suivant l'une des revendications 1 à 6, **caractérisé en ce que** l'isolation électrique des rails (2) d'alimentation est constituée par un revêtement (13) en matière isolante réalisé en partie ou complètement.

8. Agencement indiscret de mise en contact suivant l'une des revendications 1 à 7, **caractérisé en ce que** l'isolation électrique des rails (2) d'alimentation est constituée sans étanchéité et/ou est exempte de mesure constructive d'isolation électrique.

9. Agencement indiscret de mise en contact suivant l'une des revendications 1 à 8, **caractérisé en ce que** la au moins une partie (18) latérale de l'enveloppe (9) ayant un tramage (19) pour une mise en contact électrique est en un matériau non conducteur de l'électricité.

10. Agencement indiscret de mise en contact suivant l'une des revendications 1 à 9, **caractérisé en ce que** les prises (25) de contact sont constituées de manière à ce que les prises (25) de contact soient, par une force de ressort, en contact avec les rails (2) d'alimentation.

11. Utilisation d'un agencement indiscret de mise en contact suivant l'une des revendications 1 à 10 dans un centre informatique de calcul.

12. Utilisation d'un agencement indiscret de mise en contact suivant l'une des revendications 1 à 10 dans une plateforme.
